# EUROPEAN PATENT APPLICATION

(11) **EP 4 607 573 A1**
(43) Date of publication of application: **27.08.2025**
(21) Application number: 23879857.3
(22) Date of filing: 19.10.2023
(51) Int. Cl.: H01L 21/205

(54) **SEMICONDUCTOR SUBSTRATE, APPARATUS AND METHOD FOR PRODUCING SEMICONDUCTOR SUBSTRATE, AND METHOD FOR PRODUCING SEMICONDUCTOR DEVICE**

(30) Priority: 19.10.2022 WO PCT/JP2022/038988
(71) Applicant: Kyocera Corporation, Kyoto-shi, Kyoto 612-8501 (JP)
(72) Inventor: KAMIKAWA, Takeshi, Kyoto-shi, Kyoto 612-8501 (JP); KOBAYASHI, Toshihiro, Kyoto-shi, Kyoto 612-8501 (JP); SUDA, Noboru, Kyoto-shi, Kyoto 612-8501 (JP); OGURA, Hiroyuki, Kyoto-shi, Kyoto 612-8501 (JP); SEIDA, Mitsunari, Kyoto-shi, Kyoto 612-8501 (JP)
(74) Representative: Viering, Jentschura & Partner mbB Patent- und Rechtsanwälte
(86) International application number: PCT/JP2023/037823
(87) International publication number: WO 2024/085214

(57) **Abstract**

Provided are a template substrate including a growth suppression region and a first seed region aligned in a first direction, and a first semiconductor part located above the template substrate and including a nitride semiconductor. The first semiconductor part includes a first raised portion extending from the first seed region to a location above the growth suppression region, a growth suppression film in contact with the first raised portion, a first base portion located above the first raised portion, and a first wing portion connected to the first base portion, separated from the growth suppression region, and located above a void space.

## Description

### TECHNICAL FIELD

The present disclosure relates to a semiconductor substrate and the like.

### BACKGROUND OF INVENTION

For example, when a GaN layer is formed by film formation on a heterogeneous substrate, threading dislocations are generated from an interface between different materials at a defect density on the order of 10⁸ cm⁻² in a sapphire substrate and on the order of 10⁹ cm⁻² in a silicon substrate. Thus, the characteristics of a semiconductor element formed on the GaN layer deteriorate. Therefore, an Epitaxial Lateral Overgrowth (ELO) method has been studied as a technique for forming a nitride semiconductor layer (such as a GaN layer) having a low defect density on the heterogeneous substrate. For example, a mask pattern in which a nitride semiconductor layer does not grow is formed on a base substrate including a heterogeneous substrate and a seed layer, and the nitride semiconductor layer is grown in the lateral direction on a mask portion by using, as a growth starting point, the seed layer exposed in an opening portion where the mask portion is not provided. Thereby, the defect density of the nitride semiconductor layer on the mask portion can be reduced (Patent Document 1).

### CITATION LIST

### PATENT LITERATURE

Patent Document 1: JP 2013-251304 A

### SUMMARY

### PROBLEM TO BE SOLVED

In the technique of Patent Document 1, a problem is that the flatness of the nitride semiconductor layer decreases, when the nitride semiconductor layer growing in the lateral direction contacts the mask portion.

### SOLUTION TO PROBLEM

A semiconductor substrate according to the present disclosure includes a template substrate including a growth suppression region and a first seed region aligned in a first direction, and a first semiconductor part located above the template substrate and including a nitride semiconductor, in which the first semiconductor part includes a first raised portion extending from the first seed region to a location above the growth suppression region, a growth suppression film in contact with the first raised portion, a first base portion located above the first raised portion, and a first wing portion connected to the first base portion, separated from the growth suppression region, and located above a void space.

### ADVANTAGEOUS EFFECT

The first semiconductor part including the nitride semiconductor may have a low defect density and high flatness.

### BRIEF DESCRIPTION OF THE DRAWINGS

FIG. 1 is a plan view illustrating a configuration of a semiconductor substrate according to the present embodiment.
FIG. 2 is a cross-sectional view illustrating the configuration of the semiconductor substrate according to the present embodiment.
FIG. 3 is a cross-sectional view illustrating another configuration of the semiconductor substrate according to the present embodiment.
FIG. 4 is a cross-sectional view illustrating another configuration of the semiconductor substrate according to the present embodiment.
FIG. 5 is a cross-sectional view illustrating another configuration of the semiconductor substrate according to the present embodiment.
FIG. 6 is a cross-sectional view illustrating another configuration of the semiconductor substrate according to the present embodiment.
FIG. 7 is a cross-sectional view illustrating another configuration of the semiconductor substrate according to the present embodiment.
FIG. 8 is a cross-sectional view illustrating a method of manufacturing a semiconductor substrate according to the present embodiment.
FIG. 9 is a flowchart showing the method of manufacturing a semiconductor substrate according to the present embodiment.
FIG. 10 is a block diagram illustrating a manufacturing apparatus of a semiconductor substrate according to the present embodiment.
FIG. 11 is a cross-sectional view illustrating a configuration of a semiconductor substrate of Example 1.
FIG. 12 is a cross-sectional view illustrating another configuration of the semiconductor substrate of Example 1.
FIG. 13 is a cross-sectional view illustrating a method of manufacturing the semiconductor substrate of Example 1.
FIG. 14 is a cross-sectional view illustrating the method of manufacturing the semiconductor substrate of Example 1.
FIG. 15 is a cross-sectional view illustrating another configuration of the semiconductor substrate of Example 1.
FIG. 16 is a graph showing a measurement result of an XRD scan in a Comparative Example.
FIG. 17 is a graph showing a measurement result of an XRD scan in Example 1.
FIG. 18 is a plan view of a semiconductor substrate including an upper layer portion.
FIG. 19 is a cross-sectional view of the semiconductor substrate including the upper layer portion.
FIG. 20 is a plan view illustrating an element separation method in Example 1.
FIG. 21 is a cross-sectional view illustrating the element separation method in Example 1.
FIG. 22 is a schematic view illustrating a configuration of an electronic device according to Example 1.
FIG. 23 is a cross-sectional view illustrating a configuration of a semiconductor substrate according to Example 2.
FIG. 24 is a cross-sectional view illustrating a configuration of a semiconductor substrate according to Example 4.
FIG. 25 is a plan view illustrating a configuration of a semiconductor substrate according to Example 5.
FIG. 26 is a cross-sectional view illustrating a configuration of a semiconductor substrate according to Example 5.
FIG. 27 is a cross-sectional view illustrating a method of manufacturing a semiconductor substrate.
FIG. 28 is a cross-sectional view illustrating a method of manufacturing a template substrate.
FIG. 29 is a cross-sectional view illustrating a method of manufacturing a template substrate.
FIG. 30 is a cross-sectional view illustrating a method of manufacturing a template substrate.
FIG. 31 is a cross-sectional view illustrating a configuration of a semiconductor substrate according to Example 6.
FIG. 32 is a cross-sectional view illustrating a configuration of the semiconductor substrate according to Example 6.
FIG. 33 is a flowchart showing a method of manufacturing a semiconductor device according to Example 7.
FIG. 34 is a cross-sectional view illustrating a method of manufacturing the semiconductor device according to Example 7.

### DESCRIPTION OF EMBODIMENTS

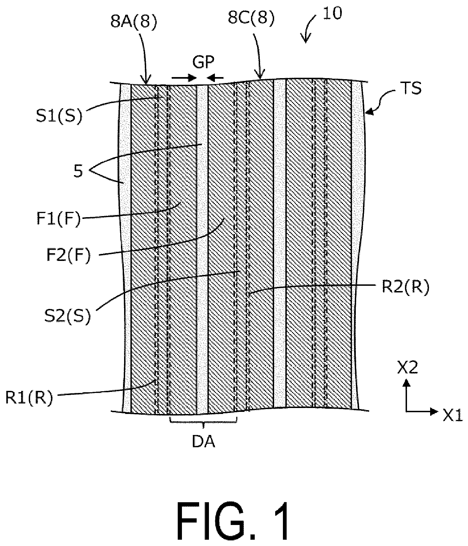

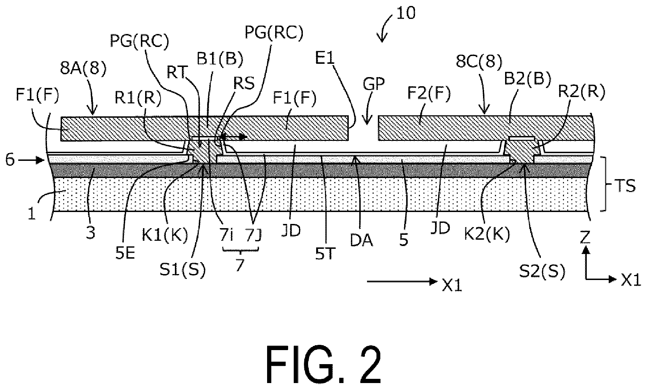

FIG. 1 is a plan view illustrating a configuration of a semiconductor substrate according to the present embodiment. FIG. 2 is a cross-sectional view illustrating the configuration of the semiconductor substrate according to the present embodiment. As illustrated in FIGs. 1 and 2, a semiconductor substrate 10 includes a template substrate TS having a mask pattern 6 including a mask portion 5 and a first opening portion K1 that are aligned in a first direction X1, and a first semiconductor part 8A located above the template substrate TS and including a nitride semiconductor. The first semiconductor part 8A includes a first raised portion R1 extending from a first seed region S1 located below the first opening portion K1 to a location above an upper surface of the mask portion 5, a first base portion B1 located above the first raised portion B1, and a first wing portion F1 that is connected to the first base portion B1, separated from the mask portion 5, and located above a void space JD. The semiconductor substrate 10 may include a growth suppression film 7 in contact with the first raised portion R1. A direction from the main substrate 1 to the first semiconductor part 8A is referred to as an "upward direction". A view in which a target subject is observed in a line of sight parallel to a normal direction of the semiconductor substrate 10 (including a view through the target subject) may be referred to as a "plan view". The mask portion 5 and the first opening portion K1 may be aligned in the first direction X1 in a plan view.

The template substrate TS may include the main substrate 1 having a different lattice constant from that of the first semiconductor part 8A, and a seed part 3 including the first seed region S1. The first opening portion K1, the first raised portion R1, and the first base portion B1 may overlap each other in a plan view, and the mask portion 5 and the first wing portion F1 may overlap each other in a plan view. The first wing portion F1 may not be in contact with a side surface of the first raised portion R1.

As illustrated in FIGs. 1 and 2, the semiconductor substrate 10 includes the template substrate TS including the first seed region S1 (an exposed surface of the seed part 3) and a growth suppression region DA (the mask portion 5) that are aligned in the first direction X1, and the first semiconductor part 8A positioned above the template substrate TS and including a nitride semiconductor. The first semiconductor part 8A includes the first raised portion R1 extending from the first seed region S1 to a location above the growth suppression region DA, the first base portion B1 located above the first raised portion B1, and the first wing portion F1 that is connected to the first base portion B1, separated from the growth suppression region DA, and located above the void space JD. The semiconductor substrate 10 may include, at a location above the growth suppression region DA, the growth suppression film 7 in contact with the first raised portion R1. The first wing portion F1 may not be in contact with the side surface of the first raised portion R1. The first seed region S1 and the growth suppression region DA may be aligned in the first direction X1 in a plan view.

The first semiconductor part 8A contains a nitride semiconductor as a main constituent. For example, the nitride semiconductor may be expressed by AlxGayInzN (0 ≤ x ≤ 1; 0 ≤ y ≤ 1; 0 ≤ z ≤ 1; x + y + z = 1). Specific examples of the nitride semiconductor include a GaN-based semiconductor, an aluminum nitride (AlN) semiconductor, an indium aluminum nitride (InAlN) semiconductor, and an indium nitride (InN) semiconductor. The GaN-based semiconductor is a semiconductor containing gallium atoms (Ga) and nitrogen atoms (N). Typical examples of the GaN-based semiconductor include GaN, AlGaN, AlGaInN, and InGaN.

The first semiconductor part 8A may be a doped type semiconductor (for example, an n-type semiconductor including a donor) or a non-doped type semiconductor. The semiconductor substrate refers to a substrate containing a semiconductor. The main substrate 1 of the template substrate TS may contain a semiconductor (for example, silicon or silicon carbide), or may not contain a semiconductor. Examples of the main substrate 1 not containing a semiconductor include a sapphire substrate. The main substrate 1 may be a stand-alone substrate (wafer). The main substrate 1 and the seed part 3 may be collectively referred to as a base substrate. The template substrate TS including the base substrate and the mask pattern 6 may be referred to as a growth substrate.

The first direction X1 may be an a-axis direction (<11-20> direction) of the first semiconductor part 8A. A second direction X2 may be an m-axis direction (<1-100> direction) of the first semiconductor part 8A (a nitride semiconductor such as a GaN semiconductor). A thickness direction Z of the first semiconductor part 8A may be a c-axis direction (<0001> direction) of the first semiconductor part 8A.

The first semiconductor part 8A can be formed by an Epitaxial Lateral Overgrowth (ELO) method with the first raised portion R1 growing from the seed part 3 exposed under the first opening portion K1 serving as a starting point. Among the first semiconductor part 8A, the base portion B1 located above the first opening portion K1 serves as a dislocation succession portion in which a large number of threading dislocations occur. The first wing portion F1 located above the mask portion 5 serves as a low defect portion having a lower threading dislocation density than that of the dislocation succession portion.

Thus, by forming the first raised portion R1 and forming the first wing portion F1 that extends in a lateral direction (a direction parallel to the first direction X1) from the first base portion B1 on the first raised portion R1, is separated from the mask portion 5, and is located on the void space JD, the first wing portion F1 having a large width, low defect density, and high flatness can be formed. The entire first wing portion F1 may be spaced apart from the mask portion 5. That is, the entire first wing portion F1 may not be in contact with the mask portion 5. Thus, the first wing portion F1 having a large width, low defect density, and high flatness can be formed.

The semiconductor substrate 10 may include a second semiconductor part 8C located above the template substrate TS. The template substrate TS may include a second seed region S2 adjacent to the first seed region S1 via the mask portion 5. The second semiconductor part 8C may include a second raised portion R2 extending from the second seed region S2 to a location above the mask portion 5, a second base portion B2 located above the second raised portion R2, and a second wing portion F2 that is connected to the second base portion B2, separated from the mask portion 5, and located above the void space JD. The first wing portion F1 and the second wing portion F2 may be aligned in the first direction X1 with a gap GP therebetween.

Below, the first raised portion R1 and the second raised portion R2 may be collectively referred to as a raised portion R, the first semiconductor part 8A and the second semiconductor part 8C may be collectively referred to as a semiconductor part 8, the first wing portion F1 and the second wing portion F2 may be collectively referred to as a wing portion F, the first base portion B1 and the second base portion B2 may be collectively referred to as a base portion B, the first opening portion K1 and the second opening portion K2 of the mask pattern 6 may be collectively referred to as an opening portion K, and the first seed region S1 and the second seed region S2 may be collectively referred to as a seed region S.

The growth suppression film 7 may be in contact with an upper surface 5T (growth suppression region DA) of the mask portion 5. The first raised portion R1 may be in contact with the upper surface 5T (growth suppression region DA) of the mask portion 5. The first raised portion R1 may raise over an end portion 5E of the mask portion 5. For example, the mask portion 5 and the growth suppression film 7 can both be made of silicon nitride. However, in this case, it is difficult to observe the growth suppression film 7 on the mask portion 5 separately from the mask portion 5. The first wing portion F1 may have an edge E1 located above the mask portion 5.

The growth suppression film 7 may be in contact with a side surface RS of the first raised portion R1. Thus, the growth of the semiconductor part 8 from the side surface RS is suppressed, so that the void space JD is easily formed. In order to achieve the effect of the present embodiment, the growth suppression film 7 may be formed on at least a part of the side surface RS of the first raised portion R1, and may include a first film portion 7j in contact with the side surface RS of the first raised portion R1 and a second film portion 7i in contact with an upper surface RT of the first raised portion R1. The growth suppression film 7 may not completely be formed as a film, and may be a film including one or more small openings (a film having an incomplete shape). By forming the second film portion 7i, a new effect can be obtained by which the threading dislocation or the like that propagates from the seed part 3 to the first raised portion R1 is suppressed by the second film portion 7i and the surface flatness and the crystallinity of the upper surface RT of the first raised portion R1 are improved.

The side surface RS of the first raised portion R1 may be a tapered surface having a shape that is narrow upward. Thus, the width of the void space JD facing the back surface of the first wing portion F1 can be made wider than the width of the void space JD facing the upper surface 5T of the mask portion 5, so that the first wing portion F1 having less defects can be formed wider. The side surface RS, which is a tapered surface, may intersect the upper surface 5T (growth suppression region DA) of the mask portion 5. The growth suppression film 7 may be in contact with the upper surface RT of the first raised portion R1. Among the growth suppression film 7 in contact with the first raised portion R1, the second film portion 7i located on the upper surface RT of the first raised portion R1 (a portion in contact with the upper surface RT of the first raised portion R1) may be included in the first semiconductor part 8A. Therefore, the stress from the template substrate TS is relaxed.

The first raised portion R1 may include a growth starting point PG of the nitride semiconductor at a location above the mask portion 5. The growth starting point PG may not be in contact with the growth suppression film 7 or may be in contact with a portion where the growth suppression film 7 is locally thinned. A corner portion RC where the upper surface RT and the side surface RS of the first raised portion R1 intersect may be included in the growth starting point PG. The corner portion RC may be located above the mask portion 5. That is, the corner portion RC and the mask portion 5 may overlap each other in a plan view.

As described above, by forming the mask pattern 6 having the opening portion K and then, forming the first raised portion R1, the corner portion RC is formed in the first raised portion R1. By forming the growth suppression film 7 in contact with the first raised portion R1, the corner portion RC of the first raised portion R1 can be utilized as the growth starting point PG. That is, by forming the first raised portion R1 of the nitride semiconductor by crystal growth from the seed part 3 (seed region) exposed in the opening portion K or by a patterning method such as dry etching, and forming the growth starting point PG at an upper end (for example, both corner portions) of the first raised portion R1, a good nitride semiconductor layer (the first base portion B1 and the first wing portion F1) can be grown even after the growth suppression film 7 is formed on the first raised portion R1, and threading dislocations on the first raised portion R1 can be reduced.

By using both corner portions of the first raised portion R1 (two corner portions RC arranged in the first direction X1) as growth starting points PG, lateral film formation occurs from both sides, and a void can be formed in the first base portion B1 (in particular, in a center portion). Thus, the first base portion B1 may include a void, and therefore, the stress from the template substrate TS is relaxed. The void may be located above the second film portion 7i of the growth suppression film 7. The growth suppression film 7 may be a silicon nitride film. The first direction X1 may be the <11-20> direction, the upper surface of the first raised portion R1 may be a polar surface, and the side surface of the first raised portion R1 may be a semi-polar surface or a non-polar surface. Thus, by using the raised portion R to form the growth suppression film 7 above the raised portion R, the nitride semiconductor can be formed by lateral film formation (growth) also above the opening portion K, and defects can be effectively suppressed also in a portion of the semiconductor part 8 located on the growth suppression film 7 above the opening portion K (for example, the base portion B).

The mask portion 5 and the first opening portion K1 may each have a shape in which the second direction X2 orthogonal to the first direction X1 is the longitudinal direction. The main substrate 1 is a silicon substrate, a sapphire substrate, or a silicon carbide substrate. The nitride semiconductor contained in the first semiconductor part 8A may be a GaN-based semiconductor.

The seed part 3 may be made of a nitride semiconductor containing 2 * 10¹⁸/cm³ or more of argon or oxygen as impurities. The mask portion 5 may have a thickness of not more than 50 nm. The thickness of the growth suppression film 7 may be smaller than that of the mask portion 5. Thus, the wing portion F easily grows from the raised portion R, while the growth on the mask portion is suppressed. The thickness of the growth suppression film 7 may be equal to or less than one third of the thickness of the mask portion 5.

When an ELO layer contacts the mask portion, the mask portion needs to have a thickness of at least 100 nm. When the mask portion and the ELO layer interfere with each other, the surface flatness of the ELO layer may be impaired. However, in Example 1, the wing portion F floats in midair and is not in contact with the mask portion 5, so that the growth of the wing portion F is not hindered, even if the mask portion 5 is strongly thinned. By thinning the mask portion 5, the flatness of the back surface of the wing portion F improves. If the thickness of the mask portion 5 is not more than 50 nm, the flatness improves. The thickness may also be equal to or less than 30 nm.

A deviation between the c-axis direction of the first base portion B1 and the c-axis direction of the edge of the first wing portion F1 may be equal to or less than 0.2 degrees. Each of the threading dislocation density in the first base portion B1 and the threading dislocation density in the first wing portion F1 may be equal to or less than 5 * 10⁶ dislocations/cm². The first semiconductor part 8A may include a pair of two first wing portions F1 extending from the first base portion B1 in the first direction X1 and in a direction opposite to the first direction X1.

A ratio of a width of the void space JD in the first direction X1 with respect to a thickness of the void space JD (an aspect ratio of the void space) is equal to or greater than 5.0. The void space JD is a space between the mask portion 5 (the growth suppression region DA) and each of the first wing portions F1. A ratio of the width of the first wing portion F1 in the first direction X1 with respect to the thickness of the first wing portion F1 may be 2.0 or more, 5.0 times or more, 10 times or more, 20 times or more, or 50 times or more. For example, the width (the width in the first direction X1) of the first wing portion F1 may be equal to or greater than 7.0 µm, equal to or greater than 10.0 µm, equal to or greater than 20.0 µm, or equal to or greater than 40.0 µm. The width of the first wing portion F1 is preferably equal to or less than 80.0 µm. This reduces the risk that the semiconductor part 8 is warped in the upward direction due to gravity. The thickness of the first wing portion F1 may be equal to or less than 10.0 µm, equal to or less than 5.0 µm, or equal to or less than 2.0 µm. As illustrated in FIG. 2, a width of the gap GP may be greater than the thickness of the void space JD. The ratio of the width of the first wing portion F1 with respect to the width of the first base portion B1 may be equal to or greater than 3.0. The thickness of the void space JD may be equal to or less than 3.0 µm. The thickness (height) of the void space JD is a distance from the upper surface (the growth suppression region DA) of the mask portion 5 to the lower surface (back surface) of the semiconductor part 8. The width of the void space JD is a distance in the first direction X1 from the side surface of the first raised portion R1 to the edge E1 of the semiconductor part 8.

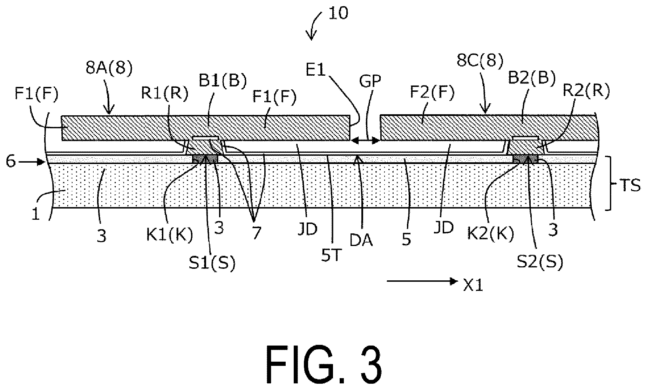

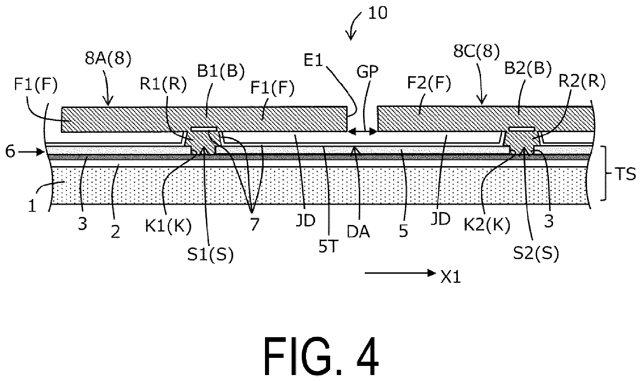

FIGs. 3 and 4 are cross-sectional views each illustrating another configuration of the semiconductor substrate according to the present embodiment. As illustrated in FIG. 3, the seed part 3 may be formed in a pattern shape (for example, a stripe shape aligned in the first direction X1), and the seed part 3 may not be disposed below the mask portion 5. As illustrated in FIG. 4, a buffer part 2 may be formed between the seed part 3 and the main substrate 1. The buffer part 2 may have a plane shape as illustrated in FIG. 4, or a pattern shape. As illustrated in FIG. 4, the buffer part 2 and the seed part 3 may have a plane shape, the buffer part 2 and the seed part 3 may have the same pattern shape, or the buffer part 2 may have a plane shape and the seed part 3 may have a pattern shape. In FIGs. 3 and 4, a silicon substrate may be used as the main substrate 1, AlN may be used in the buffer part 2, and a GaN-based semiconductor may be used as the seed part 3.

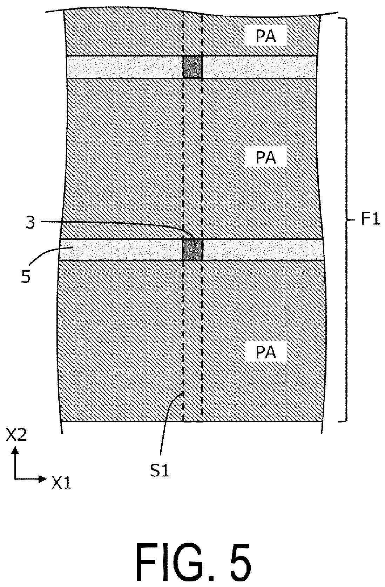

FIG. 5 is a cross-sectional view illustrating another configuration of the semiconductor substrate according to the present embodiment. As illustrated in FIG. 5, the first wing portion F1 may be divided into a plurality of parts PA aligned in the second direction X2 orthogonal to the first direction X1.

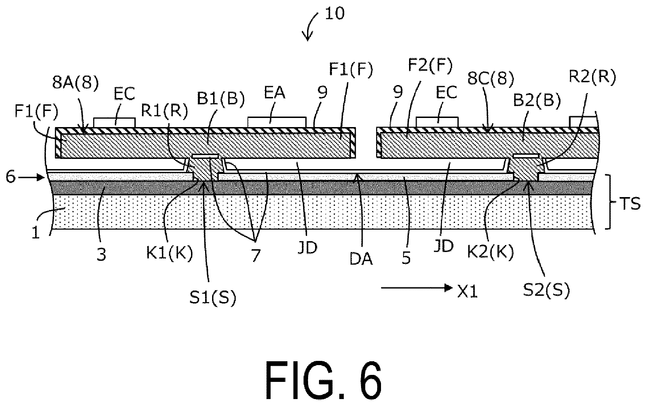

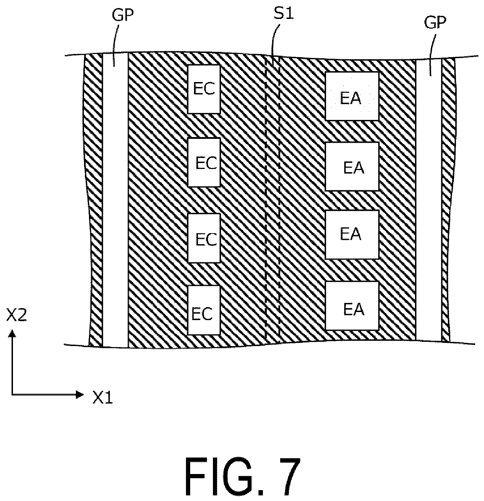

FIG. 6 is a cross-sectional view illustrating another configuration of the semiconductor substrate according to the present embodiment. FIG. 7 is a plan view illustrating another configuration of the semiconductor substrate according to the present embodiment. As illustrated in FIGs. 6 and 7, the semiconductor substrate 10 may include an upper layer portion 9 that is located above the first semiconductor part 8A and includes an active layer and a p-type layer. An anode EA and a cathode EC may be provided on the upper layer portion 9.

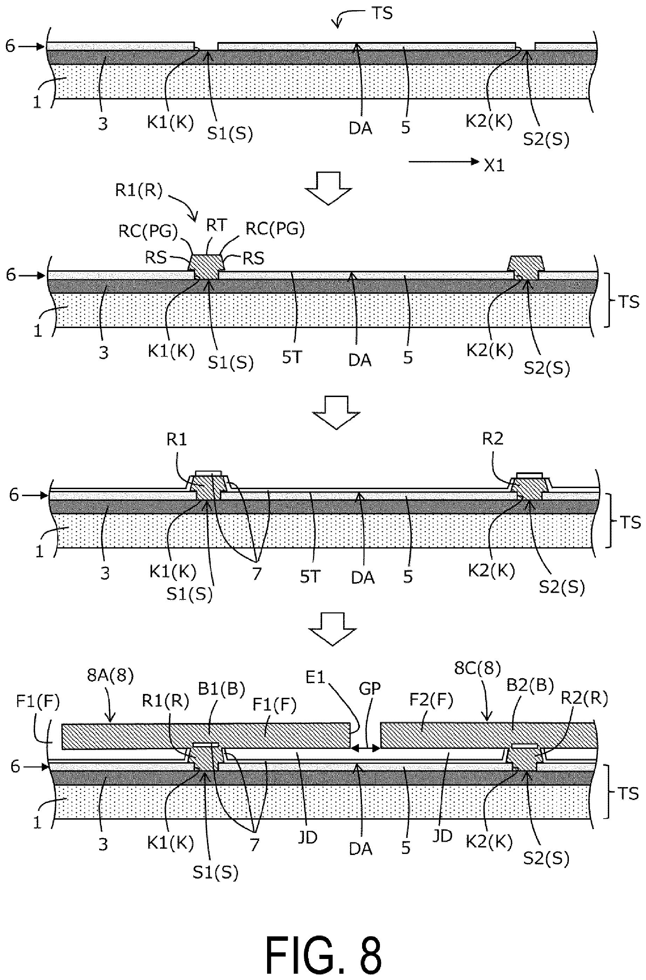

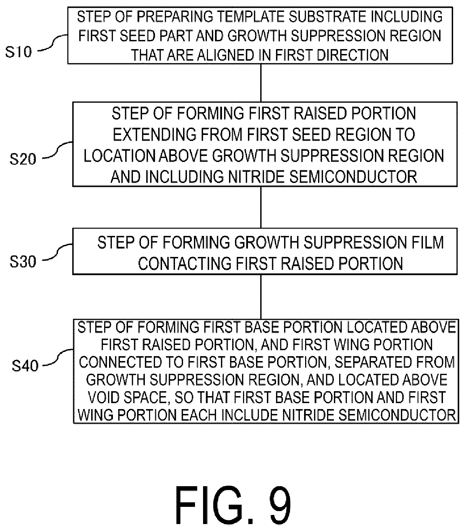

FIG. 8 is a cross-sectional view illustrating a method of manufacturing a semiconductor substrate according to the present embodiment. FIG. 9 is a flowchart showing the method of manufacturing a semiconductor substrate according to the present embodiment. As illustrated in FIGs. 8 and 9, the method of manufacturing a semiconductor substrate according to the present embodiment includes a step S10 of preparing the template substrate TS including the growth suppression region DA (the mask portion 5) and a first seed part S1 (the first opening portion K1 exposing the seed part 3) aligned in the first direction X1, a step S20 of forming the first raised portion R1 that extends from the first seed region S1 to a location above the growth suppression region DA (the upper surface 5T of the mask portion 5) and includes a nitride semiconductor, a step S30 of forming the growth suppression film 7 in contact with the first raised portion R1, and a step S40 of forming the first base portion B1 located above the first raised portion R1, and the first wing portion F1 that is connected to the first base portion B1, is separated from the growth suppression region DA (the mask portion 5), and is located above the void space JD, so that the first base portion B1 and the first wing portion F1 each include the nitride semiconductor.

The first base portion B1 and the first wing portion F1 may be formed by using, as the growth starting point PG, the corner portion RC where the upper surface RT and the side surface RS of the first raised portion R1 intersect. As described above, the first base portion B1 and the first wing portion F1 may be formed by using the corner portion RC as the growth starting point PG. However, the present embodiment is not limited thereto. Even a defect portion (for example, a small opening) may be formed in the growth suppression film 7 and the defect portion of the growth suppression film 7 may be used as a growth starting point of the first base portion B1 and the first wing portion F1.

The first raised portion R1, the growth suppression film 7, the first base portion B1, and the first wing portion F1 may be continuously formed by using a metal organic chemical vapor deposition (MOCVD) device. The first raised portion R1 includes a GaN-based semiconductor. The growth suppression film 7 includes silicon nitride. A raw material serving as a gallium source and a raw material serving as a nitrogen source are supplied to form the first raised portion R1. The supply of the raw material serving as the gallium source may be stopped and a silicon-based material may be supplied, while maintaining the supply of the raw material serving as the nitrogen source, to form the growth suppression film 7. The first base portion B1 and the first wing portion F1 may include a GaN-based semiconductor. The first base portion B1 and the first wing portion F1 may be formed by stopping the supply of the silicon-based material and supplying the raw material serving as a gallium source, while maintaining the supply of the raw material serving as a nitrogen source. A small amount of the silicon-based material may be continuously supplied at the doping level.

The growth of the first wing portion F1 and the second wing portion F2 may be stopped, before the first wing portion F1 and the second wing portion F2 growing in a direction toward the first wing portion F1 touch each other. The template substrate TS includes the seed part 3 including the first seed region S1. The seed part 3 is preferably formed by a sputtering method.

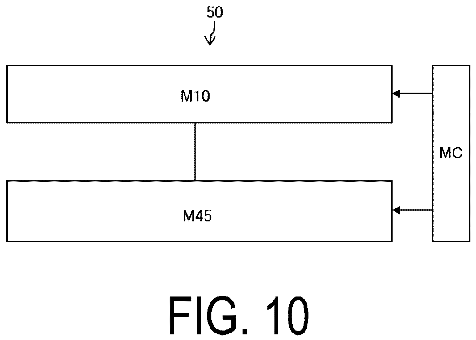

FIG. 10 is a block diagram illustrating a manufacturing apparatus of a semiconductor substrate according to the present embodiment. A manufacturing apparatus 50 of a semiconductor substrate includes a device M10 that performs the step S10 in FIG. 9, a device M45 that performs the step S20, the step S30, and the step S40 in FIG. 9, and a control device MC that controls the device M10 and the device M45. The device M45 may be an MOCVD device.

### Example 1

A silicon substrate, a silicon carbide substrate (a 4H-SiC substrate and a 6H-SiC substrate), a sapphire substrate, a nitride substrate (such as a GaN substrate and an AlN substrate), a ScMgAlO substrate, or the like can be used as the main substrate 1.

The seed part 3 is formed above the main substrate 1 and serves as a starting point from which the semiconductor part 8 grows. The seed part 3 may be formed in at least a part of the opening portion K (of the mask pattern 6), and may have a plane shape or a pattern shape (for example, a stripe shape). As the seed part 3, a GaN layer, an AlN layer, an AlGaN layer, an AlInN layer, AlGaInN, Al, or the like formed at a low temperature (a temperature equal to or lower than 500°C) may be used. The thickness of the seed part 3 is about 10 nm to 500 nm.

The buffer part 2 may be formed between the main substrate 1 and the seed part 3 (for example, a GaN layer). The buffer part 2 improves the crystallinity and the flatness of the seed part 3. The buffer part 2 may have a plane shape or a pattern shape (for example, a stripe shape) corresponding to the seed part 3. A GaN layer, an AlN layer, an AlGaN layer, an AlInN layer, AlGaInN, Al, or the like formed at a low temperature (a temperature equal to or lower than 500°C) may be used as the buffer part 2. The thickness of the buffer part 2 is about 10 nm to 500 nm. When a silicon substrate is used as the main substrate 1, it is desirable that the buffer part 2 in contact with the silicon substrate does not contain gallium in order to suppress melt back.

A layer between the main substrate 1 and the semiconductor part 8 may be referred to as an underlying layer (including the buffer part 2 and/or the seed part 3). A GaN layer may be formed as the underlying layer (for example, the seed part 3) by a sputtering method. In this case, for example, a sputtering target containing gallium nitride as a main constituent (containing gallium in an amount of 25 atm% or more) and having an oxygen content of 5 atm% or less may be used. The pressure of the sputtering gas may be less than 0.3 Pa. The sputtering method may be appropriately selected from among DC sputtering, RF sputtering, AC sputtering, DC magnetron sputtering, electron cyclotron resonance (ECR) sputtering, an RF magnetron sputtering method, a pulse sputter deposition (PSD) method, a laser ablation method, and the like.

In order to increase the crystallinity of the entire film, the sputtering target to be used may have an oxygen content of not more than 5 atm%, not more than 3 atm%, or not more than 1 atm%. The purity is also desirably as high as possible, and a content of metal impurities may be less than 0.1% or less than 0.01%. When a GaN layer is formed by a sputtering method, effects such as surface flatness, enhancement of crystallinity, and suppression of generation of surface hillocks (protrusions) can be obtained by using a gallium nitride target having a low oxygen content.

When a nitride semiconductor (such as AlN and GaN) is formed by sputtering as the underlying layer, a vacuum degree in the device before the film formation may be equal to or less than 3 * 10⁻⁵ Pa, or equal to or less than 1 * 10⁻⁵ Pa. An underlying substrate (such as a main substrate and a main substrate with a buffer) may be subjected to a pretreatment before the film formation, to remove an organic layer and/or unevenness on the surface of the underlying substrate, and thus, enabling epitaxial growth. Specific examples of the pretreatment include a reverse sputtering treatment, an acid treatment, and a UV treatment. The reverse sputtering treatment is preferable in order to avoid reattachment of impurities and the like after the treatment. The reverse sputtering treatment is a method in which atoms transformed into plasma are caused to collide with the underlying substrate to clean the surface of the underlying substrate. The temperature of the substrate during the film formation may be set to a room temperature. However, if the film is formed while the substrate is in a heated state (for example, from 400° to 1000°), the film quality can be improved.

An electrical power density during discharge may be equal to or less than 5 W/cm² or equal to or less than 1.5 W/cm². A lower limit of the electrical power density may be 0.1 W/cm² or 0.3 W/cm². The electrical power density is obtained by dividing the electrical power applied during discharge by an area of the sputtering target. When the electrical power density is too high, a raw material may be sputtered from the target in a clustered state.

In Example 1, the underlying layer (for example, the seed part) being a GaN layer was formed by an RF sputtering method. A gallium nitride target (oxygen content: 0.4 atom%) was used, a film-forming pressure was set to 0.1 Pa, and 20 to 40 sccm of nitrogen gas was introduced. Argon gas was not used in Example 1. However, needless to say, argon gas may be introduced. The discharge density was 125 W/cm², and the film-forming temperature was room temperature.

When the underlying layer (including the buffer part 2 and/or the seed part 3) is formed by using a sputtering method, a laser ablation method, or the like, an internal stress can be controlled from a compressive stress to a tensile stress by the film-forming conditions, and thus, a stress to be applied to the semiconductor part 8 can be controlled. The internal stress can also be controlled by the amount of argon introduced into the underlying layer. The stress applied to the semiconductor part 8 may be controlled by locally forming the underlying layer (in a pattern shape) on the underlying substrate.

The mask pattern 6 is formed on the base substrate by using a material that suppresses longitudinal growth (growth in the c-axis direction) of the nitride semiconductor, and thus, the mask pattern 6 enables lateral growth (for example, growth in the a-axis direction). The opening portion K (an exposed portion of the seed part 3) of the mask pattern 6 serves as a growth starting point of the semiconductor part 8. Examples of the material of the mask portion 5 of the mask pattern 6 include silicon nitride, silicon carbide, silicon carbonitride, diamond-like carbon, silicon oxide, and silicon oxynitride, titanium nitride, molybdenum nitride, tungsten nitride, tantalum carbide, and the like, which do not contain silicon, and further metals having a high melting point (such as molybdenum, tungsten, and platinum). The mask portion 5 may be a single layer film made of one of these materials, or a multi-layer film obtained by combining a plurality of these materials. A thickness of the mask portion 5 may be about 5 nm to 2 µm.

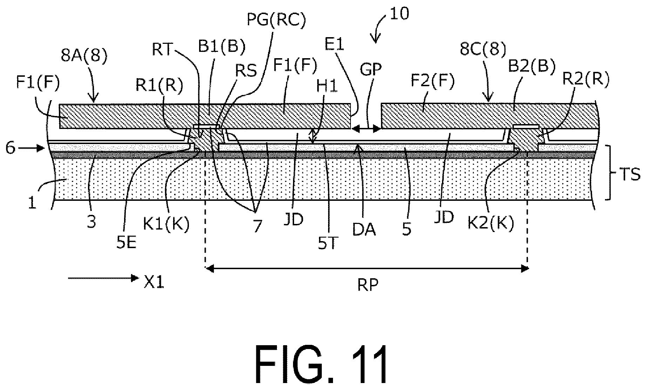

FIG. 11 is a cross-sectional view illustrating a configuration of a semiconductor substrate of Example 1. In Example 1, a silicon substrate is used as the main substrate 1, and an AlN layer serving as the seed part 3 is formed on a part of the main substrate. The crystallinity of the seed part 3 (AlN layer) can be increased by forming an Al layer having a thickness of about 1 to 5 nm as the buffer part 2 between the seed part 3 (AlN layer) and the main substrate 1 (silicon substrate).

The mask pattern 6 including the first opening portion K1 is formed on the seed part 3. The raised portion R is formed from the opening portion K. The surface of the raised portion R is located at a location higher than the upper surface 5T of the mask portion 5 by an amount H1. In order to ensure the crystallinity and the surface flatness of the semiconductor part 8, 0 < H1 < 8 µm or 0.2 µm < H1 < 4 µm may be satisfied. The raised portion R is formed by film formation in a protruding shape including the upper surface RT and the side surface RS. The upper surface RT may be a c-plane, and the side surface RS may be an (11-22) plane, an (11-20) plane, or a plane at an angle between the (11-22) plane and the (11-20) plane. The raised portion R may include the corner portion RC formed by the upper surface RT and the side surface RS. In the semiconductor substrate 10, the growth suppression film 7 having a thickness of about 0.1 nm to 10 nm is formed so as to be in contact with the raised portion R. In Example 1, SiN is used in the growth suppression film 7. Depending on the film-forming conditions, SiON, SiGaO, or SiGaON may be used as the growth suppression film 7. The growth suppression film 7 may have a uniform shape within the plane, or may have a partially defective shape (having a hole or being formed extremely thin from the periphery). The growth suppression film 7 may suppress the film formation of the semiconductor part 8 at least to some extent.

The base portion B and the wing portion F are formed above the growth suppression film 7 on the raised portion R, and are completely separated from the mask portion 5. The wing portion F of the semiconductor part 8 has a defect density lower than that of the base portion B on the opening portion K by about two orders of magnitude, and also has good crystallinity, so that the wing portion F is suitable for forming an active region of an upper layer portion (device layer). The wing portion F is a region from the upper surface edge of the raised portion R to the edge of the semiconductor part 8, and this region may be used as a device region. The back surface of the wing portion F is separated from the mask portion 5. Therefore, the wing portion F can be formed without being affected by the mask portion 5. In Example 1, semiconductor parts 8 that are adjacent to each other do not touch each other, but are separated from each other. Thus, the stress from the main substrate 1 and the seed part 3, which are formed of a material different from that of the semiconductor parts 8, can be effectively relaxed. Thus, the occurrence of cracks can be suppressed and the surface flatness of the semiconductor parts 8 can be ensured. Note that adjacent ones of the semiconductor parts 8 may touch each other.

In Example 1, the width of the opening portion K was 5 µm, the width of the mask portion 5 was 50 µm, a pitch width RP of the raised portion R was 55 µm, and the height H1 of the raised portion R was 1.5 µm. The back surface of each of the semiconductor parts 8 was at the same height as the upper surface RT of the raised portion R, and the thickness (height) of the void space JD was 1.5 µm. The growth of the semiconductor parts 8 was stopped, so that the width of the gap GP between adjacent ones of the semiconductor parts 8 was 10 µm.

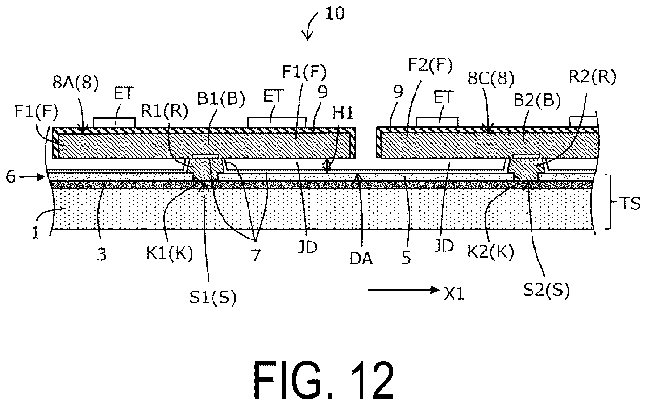

FIG. 12 is a cross-sectional view illustrating another configuration of the semiconductor substrate in Example 1. After the semiconductor parts 8 are formed, the upper layer portion 9 (device layer) is formed on each of the semiconductor parts 8. Specifically, a laminated structure of a light emitting diode (LED), a laser, a photodiode (PD), a power device, or the like can be formed by using MOCVD, molecular beam epitaxy (MBE), a sputtering method, or the like. At least a part of the active region of the upper layer portion 9 may be formed on the wing portion F (device region). In Example 1, the entire active region is formed on the wing portion F. An electrode ET (such as an anode, a cathode, and a gate) may be provided on the upper layer portion 9.

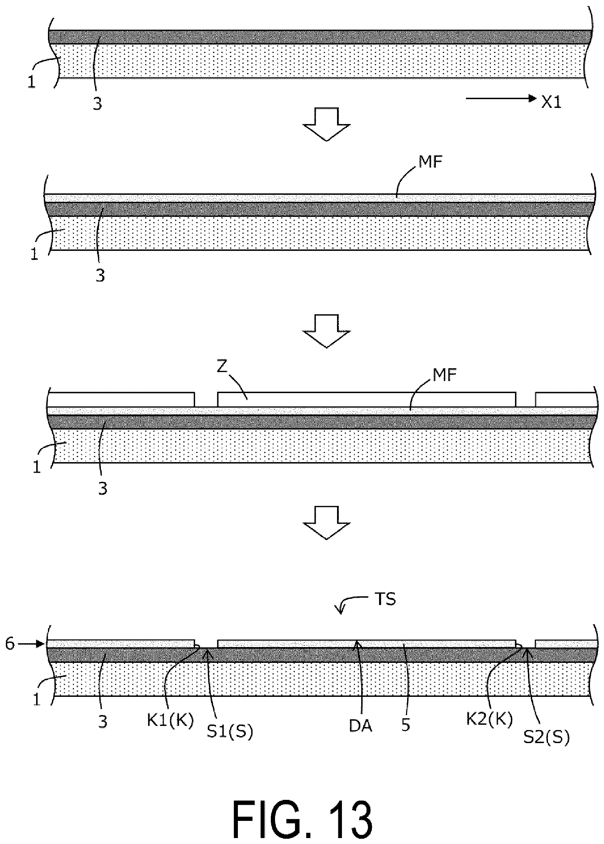

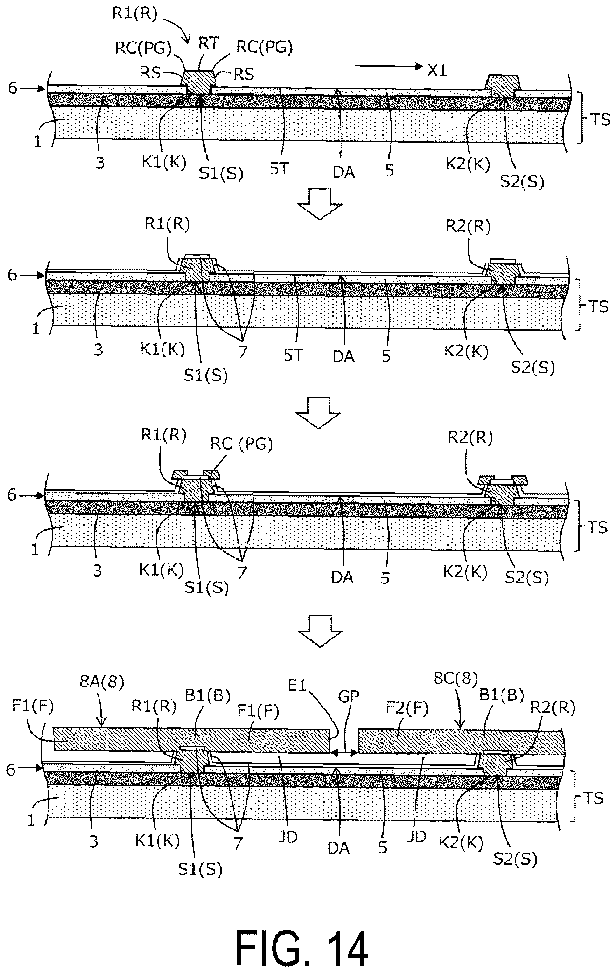

FIGs. 13 and 14 are cross-sectional views illustrating a method of manufacturing a semiconductor substrate of Example 1. As illustrated in FIG. 13, an AlN layer having a thickness of 100 nm and serving as the seed part 3 is formed on the main substrate 1 (silicon substrate) by a sputtering method. Subsequently, a mask layer MF (for example, SiN) having a thickness of 10 nm is formed on the seed part 3 (AlN layer) by using a sputtering method. Next, a resist Z applied onto the mask layer MF is patterned into a stripe shape by using a general photolithography method. Afterwards, the opening portion K and the mask portion 5 are formed in the mask layer MF by a dry etching method (for example, Ion Coupled Plasma: ICP or the like) to expose the seed part 3 (the AlN layer). Subsequently, the resist Z is removed to form the template substrate TS.

After the template substrate TS is conveyed to the MOCVD device, as illustrated in FIG. 14, a first step of film formation for ELO is performed. Thus, the raised portion R (the first raised portion R1 and the second raised portion R2) is formed. The film formation conditions included a film-forming temperature of 1100°C, an ammonia flow rate of 7.5 slm, and a trimethylgallium (TMG) flow rate of 5 sccm.

As long as the raised portion R exceeds the upper surface of the mask portion 5, the raised portion R may slightly protrude in the lateral direction from the opening portion K or may be accommodated in the opening portion K. In FIG. 14, in a state in which the raised portion R slightly protrudes from the end of the opening portion in the lateral direction, the growth of the raised portion R was stopped when the film thickness was 1.5 µm.

Next, the film-forming temperature is lowered by about 150°C from the initial growth temperature and the supply of TMG is stopped. SiH₄ (silane) is supplied at a flow rate of 400 sccm and ammonia (NH₃) is supplied at a flow rate of 7.5 slm to form a thin SiN layer (about 1 nm) by film formation. Thus, the growth suppression film 7 is formed on the side surface RS and the upper surface RT of the raised portion R.

Next, the film-forming temperature is increased by 250°C, and TMG and ammonia are supplied again to form the semiconductor part 8. At this time, the film formation of the semiconductor part 8 was understood to be greatly affected by the growth suppression film 7, and the wing portion F was formed on the raised portion R in a state of floating above the mask portion 5. That is, the back surface of the wing portion F of the semiconductor part 8 is completely separated from the mask portion 5.

The growth of the raised portion R on the side surface RS was understood to be more effectively suppressed than on the upper surface RT of the raised portion R, when the raised portion R has a protruding shape and includes the upper surface RT and the side surface RS which have different crystal orientation planes, and the corner portion RC. This unique crystal growth is a new discovery made by the inventors. The fact that the upper surface RT of the raised portion R is the c-plane (polar plane) and the side surface RS is a semi-polar plane "such as the (11-22) plane", or a non-polar plane "such as the (11-20)", affects the formation state of the growth suppression film 7 and the crystal growth state of the semiconductor part 8. As a result, the semiconductor part 8 may be formed preferentially on the upper surface RT.

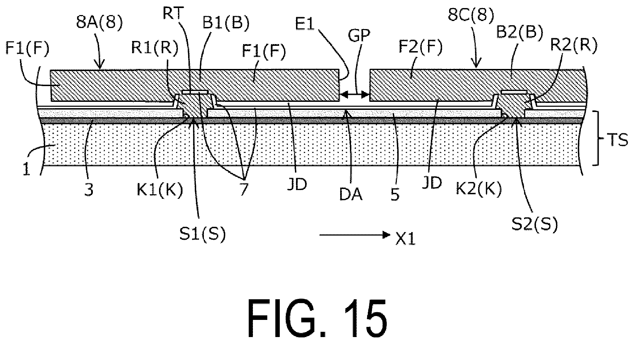

FIG. 15 is a cross-sectional view illustrating another configuration of the semiconductor substrate of Example 1. In FIG. 11, the height of the back surface of the semiconductor part 8 is formed at substantially the same height as the upper surface RT of the raised portion R. However, in FIG. 15, the height of the semiconductor part 8 is lowered to a location below the upper surface of the raised portion R, to form the semiconductor part 8 by film formation. The configuration can be selected by controlling the film-forming conditions of the semiconductor part 8 and the film-forming conditions (such as a film-forming temperature, film-forming time, and gas-flow passage) of the growth suppression film 7. In any case, the effect of Example 1 can be obtained. In FIG. 15, the height H1 of the raised portion R is 1.5 µm. However, the back surface of the semiconductor part 8 was formed at a location lower than the height of the upper surface RT of the raised portion R by 100 nm, and thus, the thickness (height) of the void space JD was 1.4 µm.

As can be understood from Example 1, the wing portion F was formed without being affected by the main substrate 1, the seed part 3, and the mask portion 5, which was very effective in suppressing the deviation of the crystal axis of the wing portion F. That is, in order to suppress the deviation of the crystal axis, the wing portion F may be completely separated from the mask portion 5. At this time, the wing portion F preferably contacts only the raised portion R, the growth suppression film 7, and the base portion B.

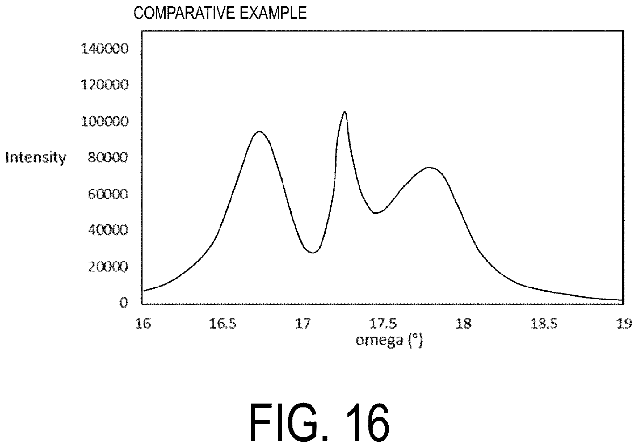

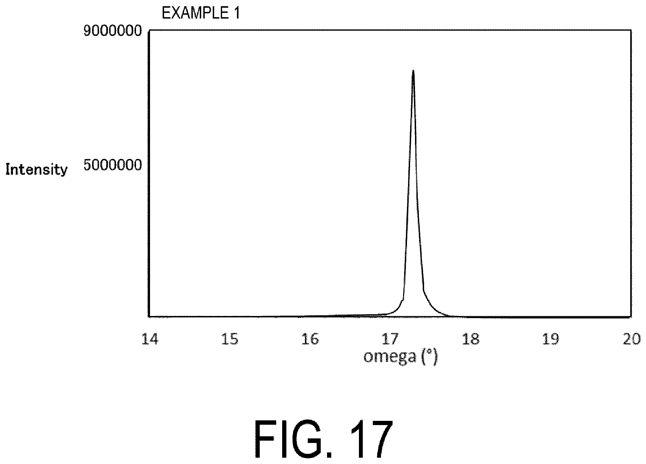

FIG. 16 is a graph showing a measurement result of an XRD scan in a Comparative Example. FIG. 17 is a graph showing a measurement result of an XRD scan in Example 1. FIGs. 16 and 17 show the measurement results of the (002) plane, and an incident direction of the X-rays is <11-20>. In Example 1, a GaN layer having a thickness of 1.5 µm is used as the seed part 3, and an AlN layer having a thickness of 200 nm is used as the buffer part 2. In the Comparative Example, the same buffer part and the same seed part as in Example 1 were used, and the ELO layer was formed so as to be in contact with the mask portion.

In FIG. 16, three peaks can be observed. The central peak is the peak of the GaN layer (base portion) on the seed part, and the crystal axis of the c-plane is substantially perpendicular to the surface of the mask portion. The remaining two peaks are peaks of the GaN layer of the wing portion, and the observed angular difference between peaks (Δ) was 0.8 degrees. This means that the c-axes of the two wing portions on both sides of the base portion grow by shifting to opposite sides from the center by about 0.4° each, and the flatness of the semiconductor part 8 is low. On the other hand, in FIG. 17 of Example 1, the peaks are not separated and form substantially one peak. This indicates that the crystal axes of the two wing portions F on both sides of the base portion B are aligned with each other and the deviation therebetween is very small.

The result of FIG. 17 represents a very good result for the semiconductor part 8 including the wing portions F having a large width. The fact that the back surface of each of the wing portions F of the semiconductor part 8 is separated from the mask portion 5 and/or the fact that the semiconductor part 8 contacts only the raised portion R is considered to contribute to the suppression of the deviation of the crystal axes of the two wing portions F on both sides of the base portion B. In Example 1, the introduction of indium (In) during the formation of the upper layer portion 9 was found to be uniform on the surface of the semiconductor part 8 and, for example, the yield and the light emission efficiency of the light emitting element were also improved.

The growth suppression film 7 in contact with the raised portion R also has an effect other than the effect of causing the semiconductor part 8 to float above the mask portion 5. When a material different from that of the semiconductor part 8 is used for at least one selected from the group consisting of the main substrate 1, the seed part 3, and the buffer part 2, stress due to differences in the thermal expansion coefficient and the lattice constant may be generated in the semiconductor part 8. However, if the growth suppression film 7 is located between the raised portion R and the semiconductor part 8, such stress was found to be relaxed and defects, cracks, or the like can be greatly suppressed in the semiconductor part 8. This effect is very important for improving the quality and yield of the upper layer portion 9.

In Example 1, the defect density of the base portion B and the wing portions F was also found to be significantly reduced. As illustrated in FIG. 14, depending on the formation state of the growth suppression film 7, the growth of the base portion B and each of the wing portions F may start from the end portions (corner portions RC) on both sides of the raised portion R, and crystals grown from these end portions (corner portions RC) toward the center may touch each other in the vicinity of the center of the upper surface of the raised portion R. Thus, the defect density of the base portion B (crystals on the raised portion R) can be reduced. By significantly reducing the defect density in the entire region (the entire width across the base portion B and the wing portion F) of the semiconductor part 8, the active region of the upper layer portion 9 can be formed also in the base portion above the opening portion. Such a technique has not been known so far, and is considered to be an industrially very effective technique.

In Example 1, the growth suppression film 7 was formed by supplying silane gas and ammonia gas. However, the growth suppression film 7 may be formed by using another method. For example, by maintaining during several minutes a state in which only ammonia gas is supplied and silane gas is not supplied when the raised portion R is formed, a coating film (the growth suppression film 7) containing silicon can be formed by residual silicon in the device so that the coating film is in contact with the raised portion R. The growth suppression film 7 containing silicon and oxygen can also be formed by temporarily removing the substrate from the MOCVD after the film formation of the raised portion R, and slightly oxidizing the surface of the raised portion. In Example 1, a silicon substrate is used as the main substrate 1. However, a SiC substrate, a sapphire substrate, or the like can also be suitably used as the main substrate 1.

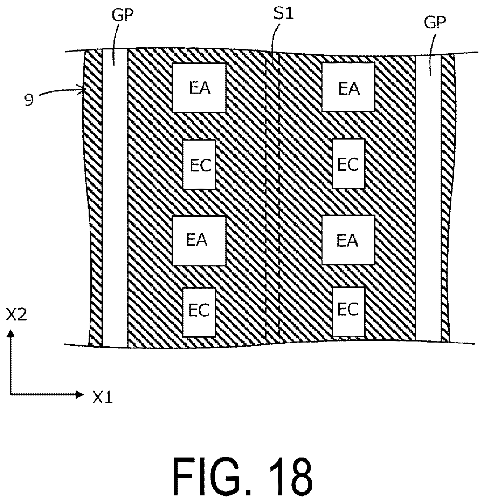

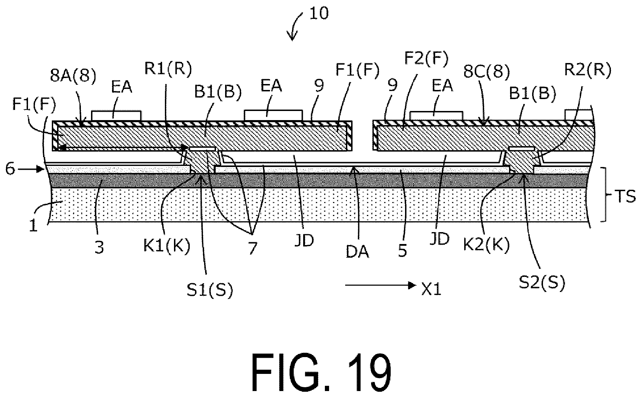

FIG. 18 is a plan view of a semiconductor substrate including an upper layer portion. FIG. 19 is a cross-sectional view of the semiconductor substrate including the upper layer portion. The upper layer portion 9 may be formed on the semiconductor part 8 by changing the film-forming conditions (for example, lowering the film-forming temperature by about 100°C) after the growth of the semiconductor part 8 is stopped. The upper layer portion 9 may include at least one selected from the group consisting of a p-type layer, an n-type layer, and an electron block layer, in addition to the active layer. Even when the upper layer portion 9 is formed on the semiconductor substrate 10, a backside overflow phenomenon in which the material of the upper layer portion is supplied to the back surface side of the semiconductor part 8 is greatly suppressed, and problems such as light absorption caused by the backside overflow phenomenon are also solved.

In the semiconductor substrate 10 illustrated in FIGs. 18 and 19, the anode EA and the cathode EC are formed above the wing portion F of the semiconductor part 8. In a typical LED, an active region (light emitting region) is formed directly below the anode EA constituted by a transparent electrode such as an indium tin oxide (ITO) electrode. In Example 1, a problem that light emitted from the active region is absorbed at the back surface of the wing portion F is solved, because the backside overflow phenomenon is suppressed. At least a part of the anode EA may be located above the wing portion F, or the entire anode EA may be located above the wing portion F. The cathode EC may be formed above the base portion B, because a region directly below the cathode EC is generally not an active region. In FIGs. 18 and 19, the anode EA and the cathode EC are formed above the same wing portion F. However, the configuration is not limited thereto. As illustrated in FIGs. 6 and 7, the anode EA may be formed above one of the two wing portions F facing each other across the base portion B, and the cathode EC may be formed above the other wing portion F.

In a known ELO method, cracks may be generated in the semiconductor layer due to a difference in the thermal expansion coefficient between a heterogeneous substrate and a semiconductor layer. On the other hand, in Example 1, the semiconductor part 8 is located on the void space and physically separated from the mask portion 5, the bonding between the raised portion R and the semiconductor part 8 is weak due to the growth suppression film 7, and adjacent ones of the semiconductor parts 8 do not touch each other (have the gap GP). By these three factors, the internal stress is effectively relaxed when a heterogeneous substrate (such as a Si substrate and a SiC substrate) is used and the occurrence of cracks is suppressed. By increasing the width of each of the wing portions F (for example, to 7 µm or more), the stress can be relaxed by the wing portion F.

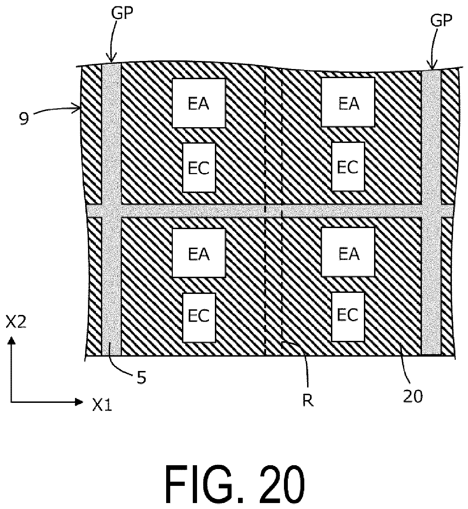

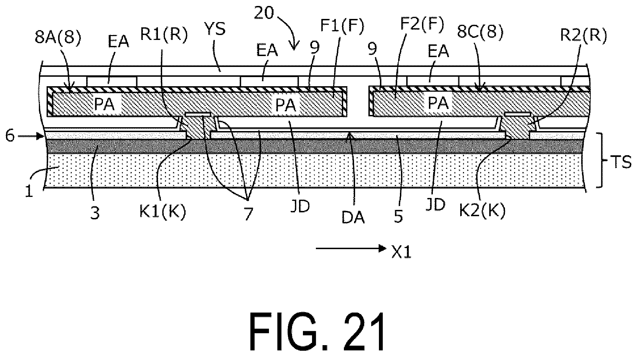

FIG. 20 is a plan view illustrating an element separation method in Example 1. FIG. 21 is a cross-sectional view illustrating the element separation method in Example 1. As illustrated in FIGs. 20 and 21, an element body 20 (including the wing portion F, the upper layer portion 9, the anode EA, and the cathode EC) is separated from the template substrate. The void space JD is provided under the wing portion F and thus, by applying a downward pressure to the element body 20 by using a pressing body YS having an adhesive property (such as an adhesive plate and an adhesive sheet), a root portion of the element body 20 (a connecting portion with the template substrate TS) easily breaks and the element body 20 is separated from the template substrate TS. Specifically, the element body 20 is peeled off from the template substrate TS while being held by the pressing body YS. As described above, the void space JD also effectively functions in separating the element body, and the element body 20 can be peeled off without damaging the element body 20.

Specific examples of the element body 20 include a light emitting diode (LED), a semiconductor laser, a Schottky diode, a photodiode, and transistors (including a power transistor and a high electron mobility transistor).

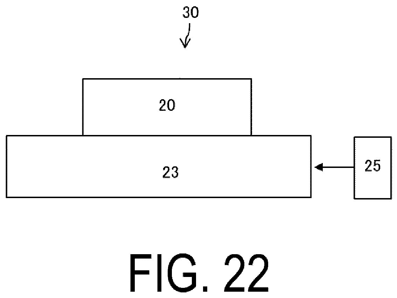

FIG. 22 is a schematic view illustrating a configuration of an electronic device according to Example 1. An electronic device 30 includes the element body 20, a drive substrate 23 to which the element body 20 is mounted, and a control circuit 25 that controls the drive substrate 23. The control circuit 25 may include a processor. Examples of the electronic device 30 include display devices, laser emitting devices (including a Fabry-Perot device and a surface light emitting device), lighting devices, communication apparatuses, information processing devices, sensing devices, and electrical power control devices.

In FIG. 22, the element body 20 is bonded and electrically connected to the drive substrate 23 while being peeled off from the template substrate TS. However, the element body 20 (the template substrate TS and the element body 20 thereon) may be bonded and electrically connected to the drive substrate 23 while not being peeled off.

### Example 2

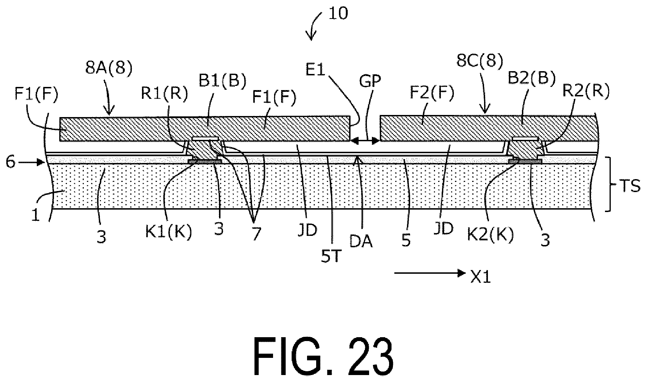

FIG. 23 is a cross-sectional view illustrating a configuration of a semiconductor substrate according to Example 2. In Example 2, the seed layer 3 does not cover the entire surface of the main substrate 1, but has a stripe shape. The opening portion K of the mask pattern 6 is present on the seed part 3 (AlN layer). In Example 2, the width of the opening portion K is slightly narrower than the width of the seed part 3, and the AlN layer (the seed part 3) is located under the opening portion K across the entire width of the opening portion K. Accordingly, the raised portion R serving as the GaN layer and the silicon substrate serving as the main substrate 1 are spatially separated by the AlN layer, and the meltback of Ga and silicon is suppressed.

By locally using the buffer layer, stress from the buffer layer can be relaxed. By forming the semiconductor part 8 and the growth suppression film 7 by film formation by the method described in Example 1, the wing portion F is completely separated from the mask portion 5, the wing portion F contacts only the raised portion R, and the deviation of the crystal axis of the wing portion F can be suppressed to a level that is the same as and/or similar to Example 1. In Example 2, a silicon substrate is used as the main substrate 1. However, a SiC substrate, a sapphire substrate, or the like is also suitable as the main substrate 1.

### Example 3

In Example 3, the semiconductor substrate in FIG. 4 was prepared. In Example 3, a GaN layer is formed as the seed part 3 on the AlN layer serving as the buffer part 2. The GaN layer serving as the seed part 3 is formed by film formation by using a sputtering method, for example. By forming the semiconductor part 8 and the growth suppression film 7 by film formation by the method described in Example 1, the wing portion F is completely separated from the mask portion 5, the wing portion F contacts only the raised portion R, and the deviation of the crystal axis of the wing portion F can be suppressed to a level that is the same as and/or similar to Example 1. In Example 2, a silicon substrate is used as the main substrate 1. However, a SiC substrate, a sapphire substrate, or the like is also suitable as the main substrate 1.

### Example 4

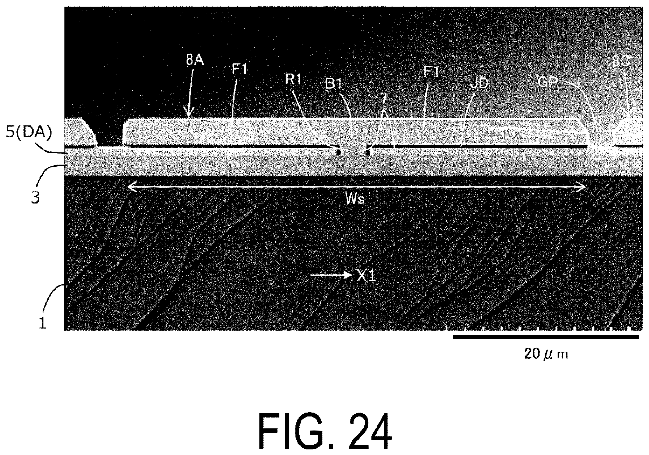

FIG. 24 is a cross-sectional image illustrating a configuration of a semiconductor substrate according to Example 4. In the semiconductor substrate 10 illustrated in FIG. 24, a width Ws (the length in the first direction) of the first semiconductor part 8A is 50.9 µm, the thickness of the void space JD is 347 nm, the thickness of the first wing portion F1 is 3.52 µm, and the width of the opening (the width of the seed region) is 3.13 µm. The first base portion B1 and the first wing portion F1 may each have a threading dislocation density of not more than 5 * 10⁶ dislocations/cm². The total width Ws (the length in the first direction) of the first semiconductor part 8A may be 5 times or more, 10 times or more, 20 times or more, or 50 times or more than the thickness of the first wing portion F1.

### Example 5

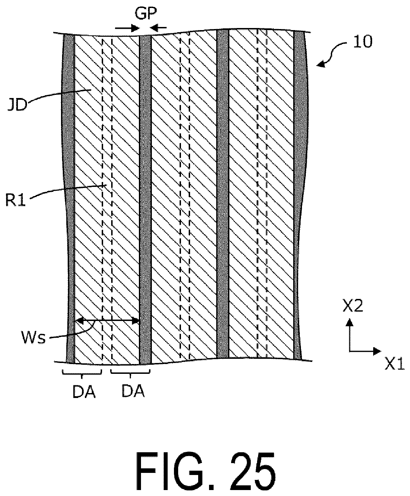

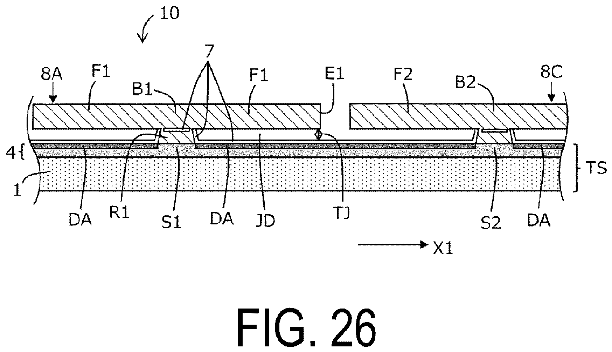

FIG. 25 is a plan view illustrating a configuration of a semiconductor substrate according to Example 5. FIG. 26 is a cross-sectional view illustrating a configuration of a semiconductor substrate according to Example 5. As illustrated in FIGs. 25 and 26, the semiconductor substrate 10 includes the template substrate TS and the first semiconductor part 8A. The template substrate TS includes a first seed region S1 and the growth suppression region (non-seed part) DA aligned in the first direction X1. The first semiconductor part 8A is located above the template substrate TS. The first semiconductor part 8A includes the first raised portion R1, the growth suppression film 7, the first base portion B 1, and the first wing portion F1. The first raised portion R1 extends from the first seed region S1 to a location above the growth suppression region DA. The growth suppression film 7 is in contact with the first raised portion R1. The first base portion B1 is located above the first raised portion R1. The first wing portion F1 is connected to the first base portion B 1, separated from the growth suppression region DA, and located above the void space JD. The first wing portion F1 may include the wing end (edge) E1 located above the growth suppression region DA. According to this configuration, the flatness of the first wing portion F1 can be increased.

In the first semiconductor part 8A, the raised portion R1 may be formed in a mesa shape on the first seed region S1 and may be connected to the first base portion B1. The growth suppression film 7 may be in contact with the side surface and the upper surface of the raised portion R1, or may be located on the growth suppression region DA.

In the semiconductor substrate 10, the template substrate TS may include the main substrate 1 and the underlying layer 4. The underlying layer 4 may be unmodified in the first seed region S1, and the underlying layer 4 may be modified in the growth suppression region DA. The ratio of a width of the void space JD in the first direction X1 with respect to a thickness (for example, a thickness below the wing end E1) TJ may be 5.0 or greater.

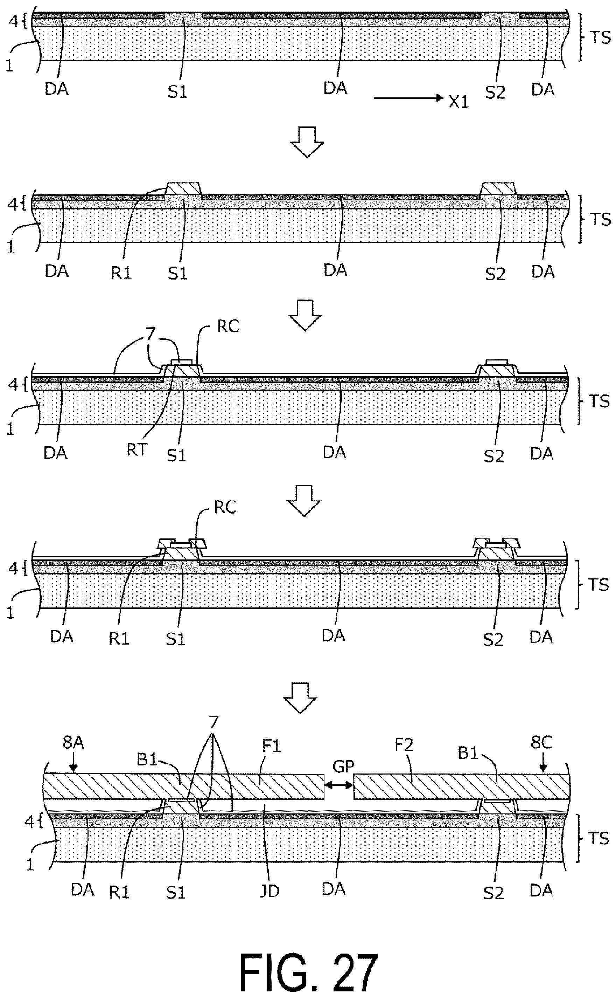

FIG. 27 is a cross-sectional view illustrating a method of manufacturing a semiconductor substrate. FIG. 27 includes a step of preparing the template substrate TS including the first seed region S1 and the growth suppression region DA, a step of forming the raised portion R1 from the first region S1 above the template substrate TS, a step of forming the growth suppression film 7 in contact with the raised portion R1, and a step of forming the first base portion B1 located above the raised portion R1, and the first wing portion F1 that is connected to the first base portion B 1, separated from the growth suppression region DA, and located above the void space JD.

As illustrated in FIG. 27, the first base portion B1 and the first wing portion F1 may be formed with the corner portion RC of the raised portion R1 as a growth starting point. As described above, the corner portion RC may be used as a growth starting point. However, the configuration is not limited thereto. A defect portion (for example, a small opening) may be formed in the growth suppression film 7 on the first raised portion R1, and the defect portion of the growth suppression film 7 may be used as a growth starting point of the first base portion B1 and the first wing portion F1.

The raised portion R1, the growth suppression film 7, the first base portion B1, and the first wing portion F1 may be continuously formed by using an MOCVD device. The first raised portion R1 includes a GaN-based semiconductor. The growth suppression film 7 includes silicon nitride. The first raised portion R1 may be formed by supplying a raw material serving as a gallium source (organic materials such as trimethylgallium (TMG) and triethylgallium (TEG)) and a raw material serving as a nitrogen source (ammonia gas (NH₃)). The growth suppression film 7 may be formed by stopping the supply of the raw material serving as the gallium source and supplying a silicon-based material (for example, SiH₄), while maintaining the supply of the raw material serving as the nitrogen source. The first base portion B1 and the first wing portion F1 may include a GaN-based semiconductor. The first base portion B1 and the first wing portion F1 may be formed by stopping the supply of the silicon-based material and supplying the raw material serving as a gallium source, while maintaining the supply of the raw material serving as a nitrogen source. A small amount of the silicon-based material may be continuously supplied at the doping level.

By forming the growth suppression film 7 as described above, film formation can be continuously performed, while forming the void space DJ under the wing portion F, without removing the product from the MOCVD device, and the manufacturing time and the manufacturing cost can be reduced. By forming the void space DJ and forming the wing portion F so as not to be in contact with the underlying layer 4 (the growth suppression region DA), the stress or the like applied to the semiconductor part 8 from the main substrate 1 and the underlying layer 4 can be effectively relaxed.

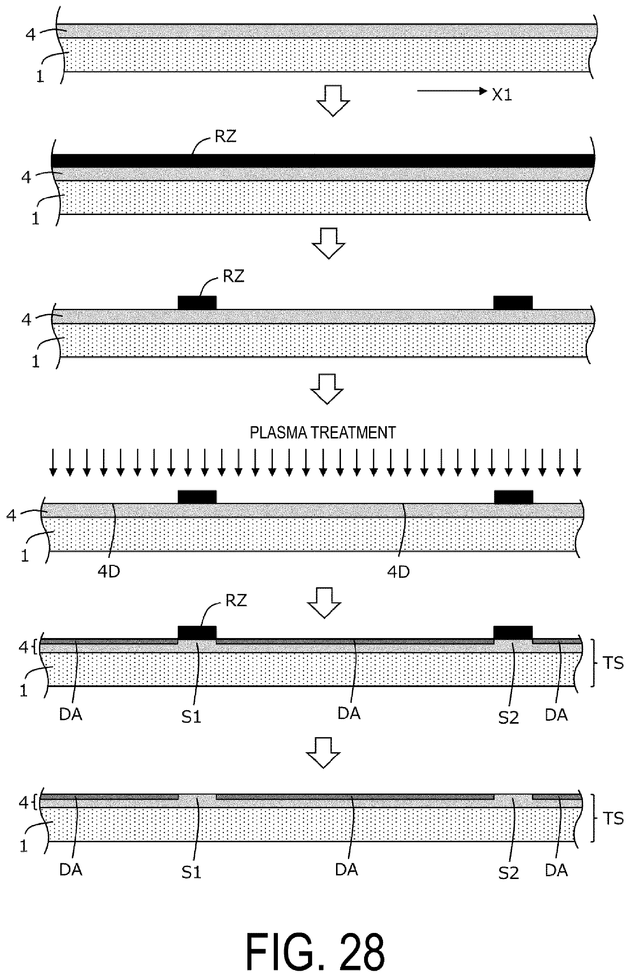

FIG. 28 is a cross-sectional view illustrating a method of manufacturing a template substrate. As illustrated in FIG. 28, the template substrate TS of FIG. 26 may be obtained by performing a step of forming the underlying layer 4 including an underlying material, a step of forming a resist RZ by film formation on the underlying layer 4, a step of patterning the resist RZ, a step of subjecting the exposed underlying material to a plasma treatment, and a step of removing the resist RZ. The underlying layer 4 may be formed by a sputtering method.

For example, in the plasma treatment, an exposed surface 4D of the underlying layer 4 is irradiated with an argon plasma to modify the surface of the irradiated regions, and form the growth suppression region DA. By introducing not only argon gas, but also oxygen gas, nitrogen gas, hydrogen gas or the like into the chamber, an oxygen plasma, a nitrogen plasma, a hydrogen plasma, or a mixed plasma of these plasma types can be used in the plasma treatment, in addition to the argon plasma. Thus, the growth suppression region DA may contain argon, oxygen, nitrogen, or the like as an impurity. In such a case, the underlying material may be aluminum nitride and the growth suppression region DA may include aluminum oxynitride. Alternatively, the underlying material may be aluminum scandium nitride (AlScN) and the growth suppression region DA may include aluminum scandium oxynitride (AlScON).

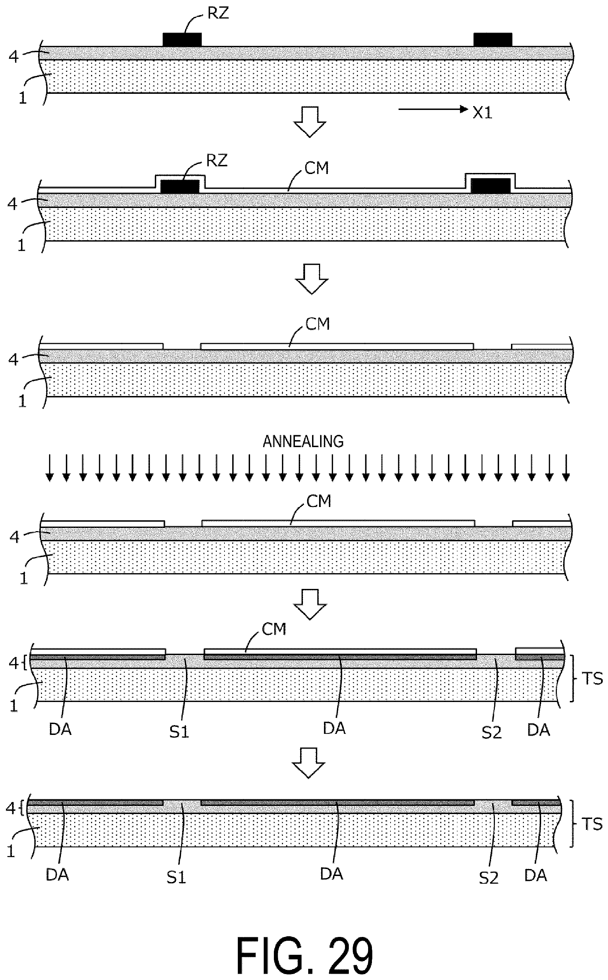

FIG. 29 is a cross-sectional view illustrating a method of manufacturing a template substrate. As illustrated in FIG. 29, the following steps may be performed: a step of forming the resist RZ by patterning on the underlying layer 4 (for example, an AlN layer), a step of forming a coating film CM (for example, a silicon nitride film of about 10 nm) covering the underlying layer 4 and the resist RZ, a step of removing the resist RZ (lift-off patterning of the coating film CM), a step of annealing the coating film CM and the underlying layer 4 (for example, by a thermal treatment at 1000°C), and a step of removing the coating film CM (for example, removing the silicon nitride film with buffered HF (BHF)). Thus, the growth suppression region DA located under the coating film CM can be formed on the surface of the underlying layer 4 by a mutual diffusion phenomenon between the underlying layer 4 and the coating film CM during annealing. By forming the coating film CM by sputtering, the surface under the coating film CM can be modified, without implementing the annealing treatment. The underlying material may contain different materials (for example, a metal element other than a group III metal element) such as scandium (Sc), Zn, and Cr, and the underlying material may be AlScN, ScN, ZnO, CrN, and the like. The underlying layer 4 may have a single-layer structure or a multi-layer structure. The multi-layer structure may include a periodic structure.

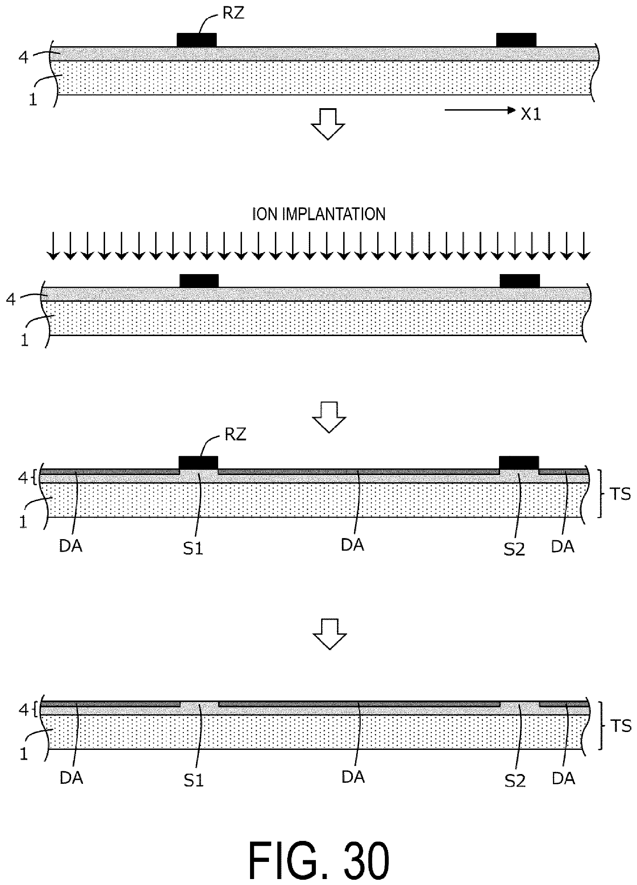

FIG. 30 is a cross-sectional view illustrating a method of manufacturing a template substrate. As illustrated in FIG. 30, a step of forming the resist RZ by patterning on the underlying layer 4 (for example, an AlN layer), a step of subjecting the exposed underlying material to an impurity ion implantation treatment, and a step of removing the resist RZ may be performed. Examples of the impurities include silicon (Si), iron (Fe), and magnesium (Mg). In the implantation treatment, impurity ions are implanted into the exposed surface 4D of the underlying layer 4 to modify the surface, and thus, the growth suppression region DA is formed. The underlying material may contain different materials (for example, a metal element other than a group III metal element) such as scandium (Sc), Zn, and Cr, and the underlying material may be AlScN, ScN, ZnO, CrN, and the like. The underlying layer 4 may have a single-layer structure or a multi-layer structure. The multi-layer structure may include a periodic structure.

### Example 6

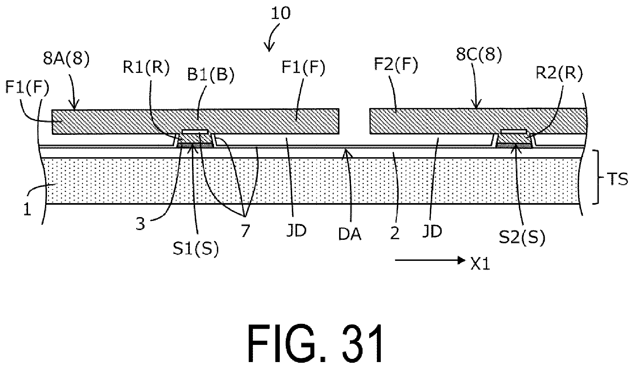

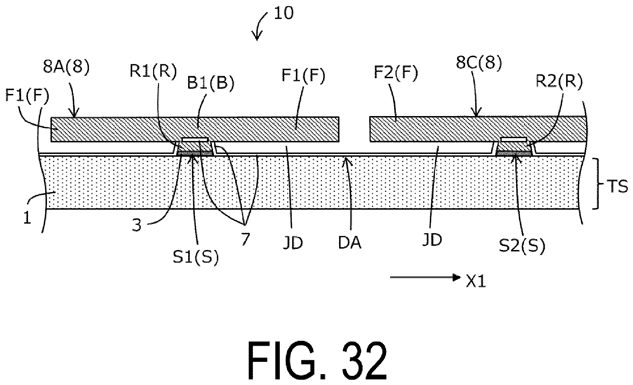

FIGs. 31 and 32 are cross-sectional views each illustrating a configuration of a semiconductor substrate according to Example 6. As illustrated in FIGs. 31 and 32, the semiconductor substrate 10 includes the template substrate TS including the first seed region S1 and the growth suppression region (non-seed part) DA aligned in the first direction X1, and the first semiconductor part 8A located above the template substrate TS. The first semiconductor part 8A includes the first raised portion R1 extending from the first seed region S1 to a location above the growth suppression region DA, the growth suppression film 7 in contact with the first raised portion R1, the first base portion B1 located above the first raised portion R1, and the first wing portion F1 that is connected to the first base portion B1, separated from the growth suppression region DA, and located above the void space JD. The first wing portion F1 may include the wing edge E1 located above the growth suppression region DA. According to such a configuration, the flatness of the first wing portion F1 can be increased.

The template substrate TS of FIG. 31 includes the main substrate 1, the buffer layer 2, and the seed part 3. The buffer layer 2 may serve as a growth suppression layer (a layer that restrains growth of a nitride semiconductor crystal). The buffer layer 2 may include at least one selected from the group consisting of a 4H-SiC layer, a 6H-SiC layer, a 3C-SiC layer, a sapphire layer, a diamond layer, and an ScAlMgO layer. The seed part 3 (for example, AlN) including the first seed region S1 is locally formed on the buffer layer 2, and a region of the buffer layer 2 that does not overlap with the seed part 3 functions as the growth suppression region DA. A Si substrate, a SiC substrate, a sapphire substrate, and the like can be used as the main substrate 1.

The template substrate TS illustrated in FIG. 32 includes the main substrate 1 and the seed part 3. The main substrate 1 may be a growth suppression substrate (a substrate that restrains growth of a nitride semiconductor crystal) such as a 3C-SiC substrate and may be, for example, a 4H-SiC substrate, a 6H-SiC substrate, a 3C-SiC substrate, a sapphire substrate, a diamond substrate, or an ScAlMgO substrate. The seed part 3 (for example, AlN) including the first seed region S1 is locally formed on the main substrate 1, and a region of the upper surface of the main substrate 1 that does not overlap with the seed part 3 functions as the growth suppression region DA.

### Example 7

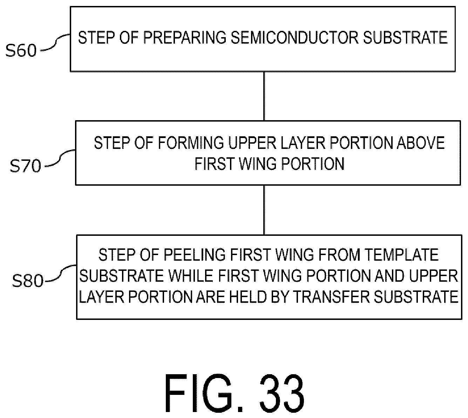

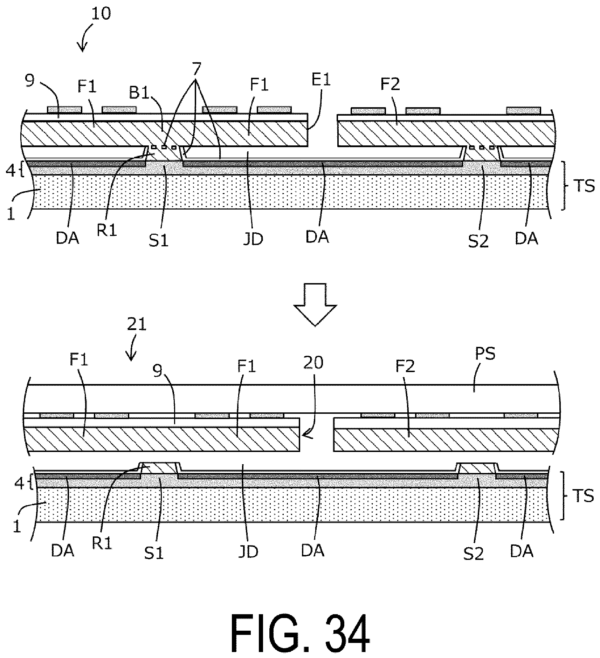

FIG. 33 is a flowchart showing a method of manufacturing a semiconductor device according to Example 7. FIG. 34 is a cross-sectional view illustrating a method of manufacturing the semiconductor device according to Example 7. As illustrated in FIGs. 33 and 34, the following steps are performed: a step S60 of preparing the semiconductor substrate 10, a step S70 of forming the upper layer portion 9 above the first wing portion F1, and a step S80 of peeling the first wing F1 from the template substrate TS while the first wing portion F1 and the upper layer portion 9 are held by a transfer substrate PS. Thereby, the element body 20 (semiconductor device) may be obtained and a semiconductor device 21 including the element body 20 and the transfer substrate PS may be obtained. For example, the upper layer portion 9 (functional layer) may be a nitride semiconductor layer (such as a GaN-based semiconductor layer) including an active layer. The semiconductor device (20 and 21) may include an electrode, and an insulating film located on the upper layer portion 9.

In the semiconductor substrate 10 of FIG. 34, the growth suppression film 7 is located on the raised portion R1, and thus, the bond between the raised portion R1 and the first wing portion F1 is weak, and the first wing portion F1 can be easily peeled off. The first wing F1 and the first base portion B1 may be peeled from the template substrate TS by performing cleaving at a boundary between the first base portion B1 and the first raised portion R1.

### Supplementary Note

The foregoing disclosure has been presented for purposes of illustration and description, and not limitation. It is noted that many variations will be apparent to those skilled in the art based on these illustrations and descriptions, and these variations are also included in the embodiments.

### REFERENCE SIGNS

1 Main substrate
2 Buffer part (buffer layer)
3 Seed part
5 Mask portion
6 Mask pattern
7 Growth suppression film
8A First semiconductor part
8C Second semiconductor part
10 Semiconductor substrate
20 Semiconductor device (element body)
25 Semiconductor device
50 Manufacturing apparatus of semiconductor substrate
DA Growth suppression region
R1 First raised portion
R2 Second raised portion
E1 Edge of first semiconductor part
B1 First base portion
B2 Second base portion
F1 First wing portion
F2 Second wing portion
JD Void space
S1 First seed region
S2 Second seed region
DA Growth suppression region
TS Template substrate

## Claims

1. A semiconductor substrate comprising:
a template substrate comprising a growth suppression region and a first seed region aligned in a first direction; and
a first semiconductor part located above the template substrate and comprising a nitride semiconductor,
the first semiconductor part comprising:
a first raised portion extending from the first seed region to a location above the growth suppression region;
a growth suppression film in contact with the first raised portion;
a first base portion located above the first raised portion; and
a first wing portion connected to the first base portion, separated from the growth suppression region, and located above a void space.

2. The semiconductor substrate according to claim 1, wherein
the first wing portion comprises a wing end located above the growth suppression region.

3. The semiconductor substrate according to claim 2, wherein
the growth suppression film is a film comprising one or more openings.

4. The semiconductor substrate according to any one of claims 1 to 3, wherein
the first wing portion is not in contact with a side surface of the first raised portion.

5. The semiconductor substrate according to claim 4, wherein
the first raised portion rises on an end portion of the growth suppression region.

6. The semiconductor substrate according to any one of claims 1 to 5, wherein
the template substrate comprises a mask portion functioning as a growth suppression region and a first opening portion that is not the mask portion; and
the first opening portion overlaps with the first seed region.

7. The semiconductor substrate according to any one of claims 1 to 6, further comprising:
a second semiconductor part located above the template substrate, wherein
the template substrate comprises a second seed region adjacent to the first seed region with the growth suppression region interposed between the first seed region and the second seed region,
the second semiconductor part comprises:
a second raised portion extending from the second seed region to a location above the growth suppression region;
a second base portion located above the second raised portion; and
a second wing portion connected to the second base portion, separated from the growth suppression region, and located above a void space, and
the first wing portion and the second wing portion are aligned in the first direction via a gap.

8. The semiconductor substrate according to any one of claims 1 to 7, wherein
the growth suppression film is in contact with the side surface of the first raised portion.

9. The semiconductor substrate according to claim 8, wherein
the side surface is a tapered surface that is narrow upward.

10. The semiconductor substrate according to claim 9, wherein
the tapered surface intersects an upper surface of the growth suppression region.

11. The semiconductor substrate according to claim 8, wherein
the growth suppression film is in contact with an upper surface of the first raised portion.

12. The semiconductor substrate according to claim 11, wherein
a portion of the growth suppression film that is in contact with the upper surface of the first raised portion is included in the first semiconductor part.

13. The semiconductor substrate according to claim 8, wherein
the first raised portion comprises a growth starting point of a nitride semiconductor at a location above the growth suppression region.

14. The semiconductor substrate according to claim 13, wherein
the growth starting point is not in contact with the growth suppression film or is in contact with a portion where the growth suppression film is locally thinned.

15. The semiconductor substrate according to claim 13, wherein
the growth starting point comprises a corner portion where the upper surface and the side surface of the first raised portion intersect.

16. The semiconductor substrate according to claim 15, wherein
the corner portion is located above the growth suppression region.

17. The semiconductor substrate according to claim 2, wherein
the first base portion comprises a void.

18. The semiconductor substrate according to claim 2, wherein
the growth suppression film is a silicon nitride film.

19. The semiconductor substrate according to any one of claims 1 to 18, wherein
the first direction is a <11-20> direction;
an upper surface of the first raised portion is a polar surface; and
a side surface of the first raised portion is a semi-polar surface or a non-polar surface.

20. The semiconductor substrate according to any one of claims 1 to 19, wherein
the growth suppression region and the first seed region each have a shape having a longitudinal direction in a second direction orthogonal to the first direction.

21. The semiconductor substrate according to claim 20, wherein
the first wing portion is divided into a plurality of parts aligned in the second direction.

22. The semiconductor substrate according to any one of claims 1 to 21, wherein
the template substrate comprises:
a main substrate having a lattice constant different from a lattice constant of the first semiconductor part; and
a seed part comprising the first seed region.

23. The semiconductor substrate according to claim 22, wherein
the main substrate is a silicon substrate, a sapphire substrate, or a silicon carbide substrate; and
the nitride semiconductor is a GaN-based semiconductor.

24. The semiconductor substrate according to claim 22 or 23, wherein
the seed part is not disposed under the growth suppression region.

25. The semiconductor substrate according to any one of claims 22 to 24, wherein
the seed part is made of a nitride semiconductor comprising argon or oxygen at 2 * 10¹⁸/cm³ or more as an impurity.

26. The semiconductor substrate according to claim 6, wherein
a thickness of the mask portion is equal to or less than 50 nm.

27. The semiconductor substrate according to claim 6, wherein
the growth suppression film is thinner than the mask portion.

28. The semiconductor substrate according to claim 2, wherein
a deviation between a c-axis direction of the first base portion and a c-axis direction of the wing end is equal to or less than 0.2 degrees.

29. The semiconductor substrate according to any one of claims 1 to 28, further comprising:
an upper layer portion positioned above the first semiconductor part and comprising an active layer and a p-type layer.

30. The semiconductor substrate according to any one of claims 1 to 29, wherein
a threading dislocation density in the first base portion and a threading dislocation density in the first wing portion are each equal to or less than 5 * 10⁶ dislocations/cm².

31. The semiconductor substrate according to any one of claims 1 to 30, wherein
the first semiconductor part comprises a pair of two first wing portions extending from the first base portion in the first direction and in a direction opposite to the first direction.

32. The semiconductor substrate according to any one of claims 1 to 21, wherein
the template substrate comprises a main substrate and an underlying layer;
the underlying layer is not modified in the first seed region; and
the underlying layer is modified in the growth suppression region.

33. The semiconductor substrate according to any one of claims 1 to 21, wherein
the template substrate comprises a buffer layer and a seed part that is locally located on the buffer layer and comprises the first seed region; and
a region of the buffer layer that does not overlap the seed part functions as a growth suppression region.

34. A method of manufacturing a semiconductor substrate, the method comprising:
preparing a template substrate comprising a growth suppression region and a first seed region aligned in a first direction;
forming a first raised portion extending from the first seed region to a location above the growth suppression region and comprising a nitride semiconductor;
forming a growth suppression film in contact with the first raised portion; and
forming a first base portion located above the first raised portion and a first wing portion connected to the first base portion, separated from the growth suppression region, and located above a void space, for each of the first base portion and the first wing portion to comprise a nitride semiconductor.

35. The method of manufacturing a semiconductor substrate according to claim 34, wherein
the first base portion and the first wing portion are formed with a corner portion where an upper surface and a side surface of the first raised portion intersect as a growth starting point.

36. The method of manufacturing a semiconductor substrate according to claim 34 or 35, wherein
the first raised portion, the growth suppression film, the first base portion, and the first wing portion are continuously formed by using an MOCVD device.

37. The method of manufacturing a semiconductor substrate according to claim 36, wherein
the first raised portion comprises a GaN-based semiconductor;
the growth suppression film is made of silicon nitride;
the first raised portion is formed by supplying a raw material serving as a gallium source and a raw material serving as a nitrogen source; and
the growth suppression film is formed by stopping a supply of the raw material serving as the gallium source and supplying a silicon-based material, while maintaining a supply of the raw material serving as the nitrogen source.

38. The method of manufacturing a semiconductor substrate according to claim 37, wherein
the first base portion and the first wing portion comprise a GaN-based semiconductor; and
the first base portion and the first wing portion are formed by stopping a supply of the silicon-based material and supplying the raw material serving as the gallium source, while maintaining the supply of the raw material serving as the nitrogen source.

39. The method of manufacturing a semiconductor substrate according to any one of claims 34 to 38, wherein
the template substrate comprises a second seed region adjacent to the first seed region via the growth suppression region;
a second raised portion extending from the second seed region to a location above the growth suppression region, a second base portion located above the second raised portion, and a second wing portion connected to the second base portion, separated from the growth suppression region, and located on a void space are formed, for each of the second raised portion, the second base portion, and the second wing portion to comprise a nitride semiconductor; and
a growth of the first wing portion and the second wing portion is stopped before the first wing portion and the second wing portion growing in a direction toward the first wing portion touch each other.

40. The method of manufacturing a semiconductor substrate according to any one of claims 34 to 39, wherein
the template substrate comprises a seed part comprising the first seed region; and
the seed part is formed by a sputtering method.

41. A method of manufacturing a semiconductor device, the method comprising:
preparing the semiconductor substrate according to any one of claims 1 to 33;
forming an upper layer portion above the first wing portion; and
peeling the first wing portion from the template substrate while the first wing portion and the upper layer portion are held by a transfer substrate.

42. The method of manufacturing a semiconductor device according to claim 41, wherein
the first wing portion is peeled from the template substrate by performing cleaving at a boundary between the first base portion and the first raised portion.
